# EUROPEAN PATENT APPLICATION

(11) **EP 3 255 441 A1**
(43) Date of publication of application: **13.12.2017**
(21) Application number: 16746469.2
(22) Date of filing: 27.01.2016
(51) Int. Cl.: G01R 19/00, G01R 15/20

(54) **ELECTRIC CURRENT SENSOR**

(30) Priority: 06.02.2015 JP 2015022254
(71) Applicant: Hitachi Automotive Systems, Ltd., Hitachinaka-shi, Ibaraki 312-8503 (JP)
(72) Inventor: KATO Takeshi, Hitachinaka-shi Ibaraki 312-8503 (JP); GORAI Nobuaki, Hitachinaka-shi Ibaraki 312-8503 (JP)
(74) Representative: MERH-IP Matias Erny Reichl Hoffmann Patentanwälte PartG mbB
(86) International application number: PCT/JP2016/052223
(87) International publication number: WO 2016/125638

(57) **Abstract**

Provided is an electric current sensor with which it is possible to reduce errors arising between the true value of an alternating current and a current value inferred from a detection signal during detection of the alternating current by the electric current sensor. The electric current sensor is provided with a magnetic flux detection unit 11 for detecting the alternating current by detecting the magnetic flux produced by the alternating current flowing through a bus bar, and a memory 15 for storing settings data based on detection values resulting from the detection of a prescribed calibration current flowing through the bus bar by the magnetic flux detection unit 11.

## Description

### Technical Field

The present invention relates to a current sensor.

### Background Art

A current sensor includes setting data that associates the magnitude of current with detection signals in a predetermined correspondence relationship. The current sensor outputs a detection signal corresponding to the magnitude of detected current based on the setting data. In some cases, the current sensor cannot continuously output a predetermined detection signal corresponding to the magnitude of detected current due to various causes such as an environmental change. To solve the problem, the current sensor is calibrated to correct the setting data.

The calibration is generally performed by letting the current sensor detect direct current as described in PTL 1.

### Citation List

### Patent Literature

PTL 1: JP 2001-124802 A

### Summary of Invention

### Technical Problem

The current sensor may detect alternating current, not direct current. In this case, when the alternating current is detected with use of setting data corrected based on calibration using direct current, there is a problem in which an error is generated between a current value derived from a detection signal and a true value of the alternating current.

### Solution to Problem

A current sensor according to a preferable aspect of the present invention includes: a current detection unit that detects alternating current flowing in a conductor; and a storage unit that stores correction data based on a detection value of predetermined calibration alternating current flowing in the conductor, the detection value being detected by the current detection unit.

### Advantageous Effects of Invention

According to the present invention, when alternating current is detected with use of a current sensor, an error generated between a current value derived from a detection signal and a true value of the alternating current can be reduced.

### Brief Description of Drawings

[FIG. 1] FIG. 1 illustrates a state in which a current sensor has been implemented in an inverter.
[FIG. 2] FIG. 2 illustrates the state in which the current sensor has been implemented in the inverter (a view taken along the arrow of FIG. 1).
[FIG. 3] FIG. 3 illustrates a current sensor circuit and peripheral components thereof.
[FIGS. 4(a) and 4(b)] FIGS. 4(a) and 4(b) illustrate a frequency skin effect.
[FIG. 5] FIG. 5 illustrates detected magnetic flux caused by the frequency skin effect.
[FIG. 6] FIG. 6 illustrates calibration according to a first embodiment.
[FIG. 7] FIG. 7 is a flowchart of the calibration.
[FIG. 8] FIG. 8 illustrates an area of calibration using alternating current.
[FIG. 9] FIG. 9 illustrates an area of calibration using direct current.
[FIGS. 10(a) and 10(b)] FIGS. 10(a) and 10(b) illustrate a state of interference of magnetic flux at the time of multiphase alternating current electric conduction.
[FIG. 11] FIG. 11 illustrates output voltage of the current sensor at the time of the multiphase alternating current electric conduction.
[FIG. 12] FIG. 12 illustrates calibration according to a second embodiment.
[FIG. 13] FIG. 13 illustrates a configuration of a power inversion device (inverter device).
[FIG. 14] FIG. 14 illustrates calibration according to a third embodiment.
[FIG. 15] FIG. 15 illustrates calibration according to a fourth embodiment.

### Description of Embodiments

### First Embodiment

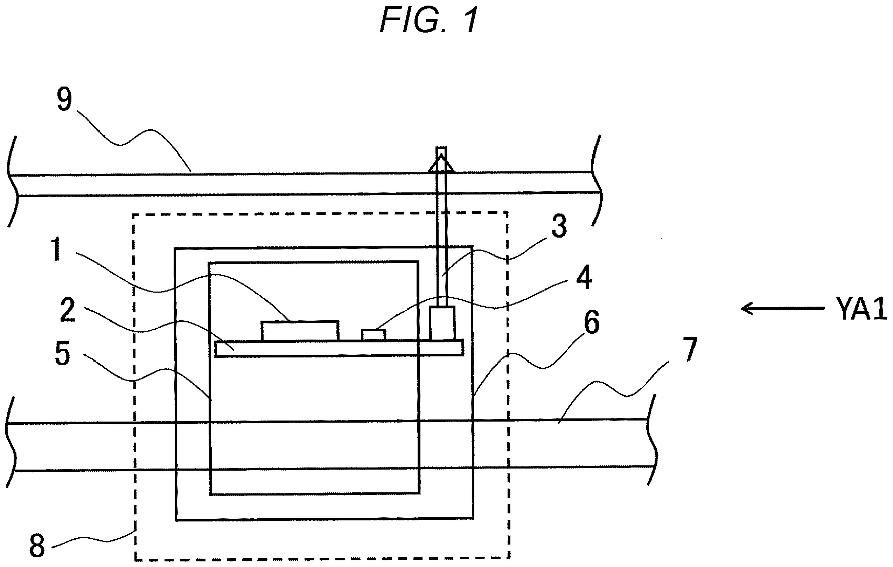

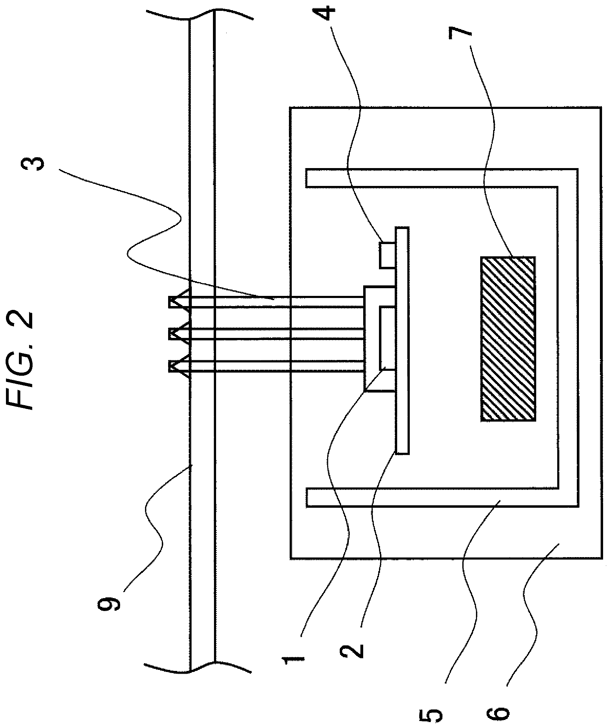

FIGS. 1 and 2 illustrate an example in which a current sensor 8 according to the present embodiment has been implemented in an inverter device. FIG. 2 is a view taken along the arrow YA1 of FIG. 1.

A bus bar 7 is made of a conductor such as copper. The bus bar 7 is a part of a main circuit of the inverter. Current output from a power module or the like flows in the bus bar 7. When the current flows in the bus bar 7, magnetic flux is generated, centering on the bus bar 7.

The current sensor 8 detects the magnetic flux generated by the current flowing in the bus bar 7 and outputs a detection signal to an inverter circuit board 9.

The inverter circuit board 9 is a control board of the inverter and performs feedback control with use of the detection signal received from the current sensor 8.

A configuration of the current sensor 8 will be described. The current sensor 8 includes a current sensor circuit 1, a current sensor board 2, a communication terminal 3, a peripheral electronic component 4, a magnetic shield 5, and a structure mold 6.

The communication terminal 3 is a terminal that electrically connects the current sensor circuit 1 to the inverter circuit board 9. The communication terminal 3 transmits a signal of the current sensor circuit 1 to the inverter circuit board 9. The communication terminal 3 also transmits a signal from the inverter circuit board 9 to the current sensor circuit 1. Details of transmission of the signal from the inverter circuit board 9 to the current sensor circuit 1 will be described below. The communication terminal 3 further transmits electric power for use in operation of the current sensor circuit 1.

The current sensor circuit 1 detects the magnetic flux generated by the current flowing in the bus bar 7 and outputs a detection signal to the inverter circuit board 9 via the communication terminal 3. Details of the current sensor circuit 1 will be described below.

The peripheral electronic component 4 is a peripheral RC chip component mounted on the current sensor board 2.

The current sensor board 2 is a board on which the current sensor circuit 1, the communication terminal 3, and the peripheral electronic component 4 are mounted. The current sensor board 2 is fixed to the bus bar 7 via the structure mold 6 so that the current sensor circuit 1 may be located away from the bus bar 7 as much as a predetermined distance.

The magnetic shield 5 is provided to decrease an influence of a magnetic noise. As illustrated in FIG. 2, the magnetic shield 5 is formed in a rectangular U shape to surround the bus bar 7 and the current sensor board 2.

The structure mold 6 is a structure mold that structurally holds the current sensor board 2, the magnetic shield 5, and a part of the bus bar 7.

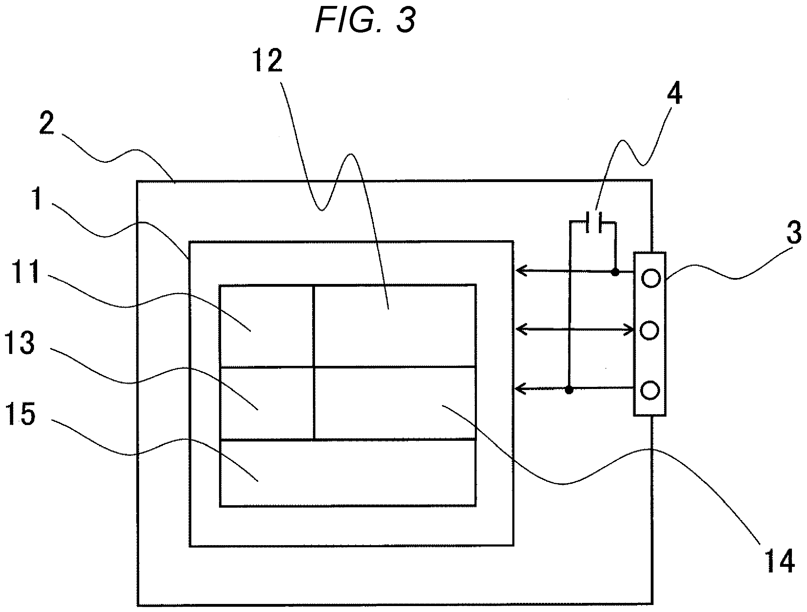

FIG. 3 illustrates the current sensor circuit 1 and peripheral components thereof.

The current sensor circuit 1 includes a magnetic flux detection unit 11, a signal adjustment unit 12, a control unit 13, a communication unit 14, and a memory 15.

The control unit 13 controls operations of the respective other components of the current sensor circuit 1.

The memory 15 is a data-rewritable memory such as an EEPROM. The memory 15 stores setting data including offset data and output gain data. The setting data stored in the memory 15 is output to the signal adjustment unit 12 by the control unit 13 as needed. Also, at the time of below-mentioned calibration of the setting data, the setting data stored in the memory 15 is corrected by the control unit 13.

The magnetic flux detection unit 11 detects current flowing in the bus bar 7. Specifically, the magnetic flux detection unit 11 includes a hall element and detects magnetic flux generated by the current flowing in the bus bar 7 by means of the hall element to detect the current flowing in the bus bar 7. The magnetic flux detection unit 11 then outputs a voltage signal corresponding to the magnitude of the detected current to the signal adjustment unit 12.

The signal adjustment unit 12 generates a detection signal based on the resultant current detected by the magnetic flux detection unit 11 and the setting data stored in the memory 15. Specifically, the signal adjustment unit 12 generates the detection signal by doing offset adjustment and gain adjustment of the voltage signal received from the magnetic flux detection unit 11 based on the setting data stored in the memory 15 and output from the control unit 13. The signal adjustment unit 12 is designed to erase stored setting data each time the electric power supply is stopped. Thus, the signal adjustment unit 12 receives setting data from the control unit 13 each time the current sensor circuit 1 is activated.

The communication unit 14 outputs the detection signal obtained from the signal adjustment unit 12 to the inverter circuit board 9 (refer to FIG. 1) via the communication terminal 3. The communication unit 14 also receives correction data for correcting the setting data from an outside via the communication terminal 3 at the time of the calibration of the setting data stored in the memory 15. That is, the communication terminal 3 is used when the communication unit 14 outputs the detection signal and receives the correction data.

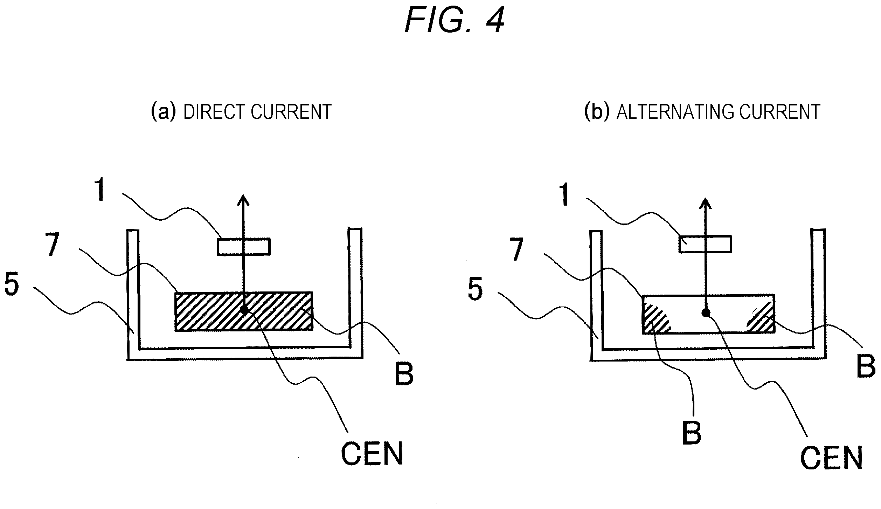

Each of FIGS. 4(a) and 4(b) illustrates a distribution of magnetic flux density B generated in the bus bar 7 when current flows in the bus bar 7. FIG. 4(a) illustrates a case in which direct current flows while FIG. 4(b) illustrates a case in which alternating current flows. In the case in which direct current flows, the current density in the bus bar 7 is distributed uniformly. Thus, the magnetic flux density B is also distributed uniformly as illustrated in FIG. 4(a). Conversely, in the case in which alternating current flows, the current is concentrated on the corners of the bus bar 7 due to a skin effect. Thus, the magnetic flux density B is also concentrated on the corners of the bus bar 7 as illustrated in FIG. 4(b).

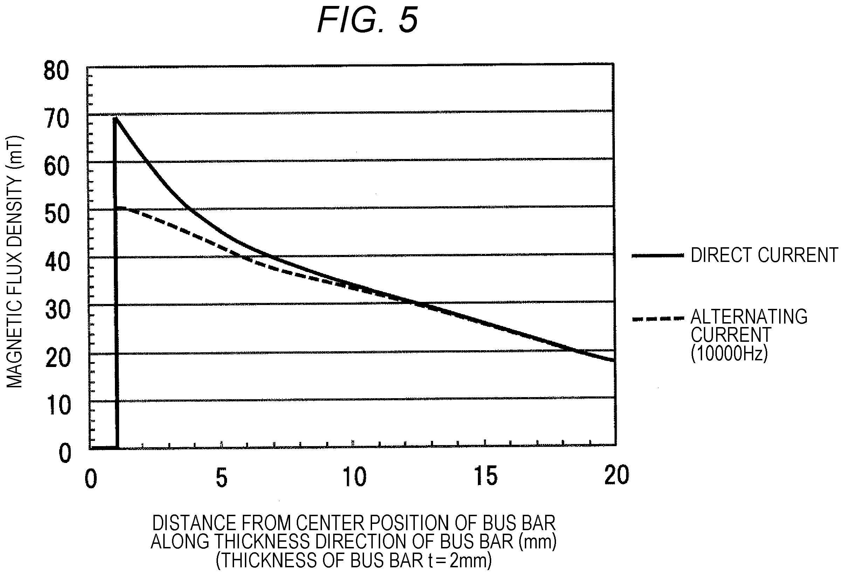

FIG. 5 illustrates a result of current flow under each of the conditions illustrated in FIGS. 4(a) and 4(b) and illustrates magnetic flux density against a distance from a center position CEN of the bus bar 7 illustrated in each of FIGS. 4(a) and 4(b) along a thickness direction of the bus bar 7 (refer to FIGS. 4(a) and 4(b)). The solid-line graph in FIG. 5 represents the result of direct current illustrated in FIG. 4(a). The dashed-line graph in FIG. 5 represents the result of alternating current (frequency: 10000 Hz) illustrated in FIG. 4(b). As is apparent from FIG. 5, a larger difference occurs in the magnetic flux density between the alternating current and the direct current at a closer position to the center position CEN. Specifically, in a case in which the distance between the current sensor circuit 1 and the center position CEN is 5 mm, for example, a detection value of the alternating current differs from a detection value of the direct current as much as the magnetic flux density of 3 mT or so. Since such a difference is generated, it is not preferable to perform calibration using direct current and then detect alternating current. That is, in a case in which alternating current is to be detected, calibration for this needs to be performed using alternating current.

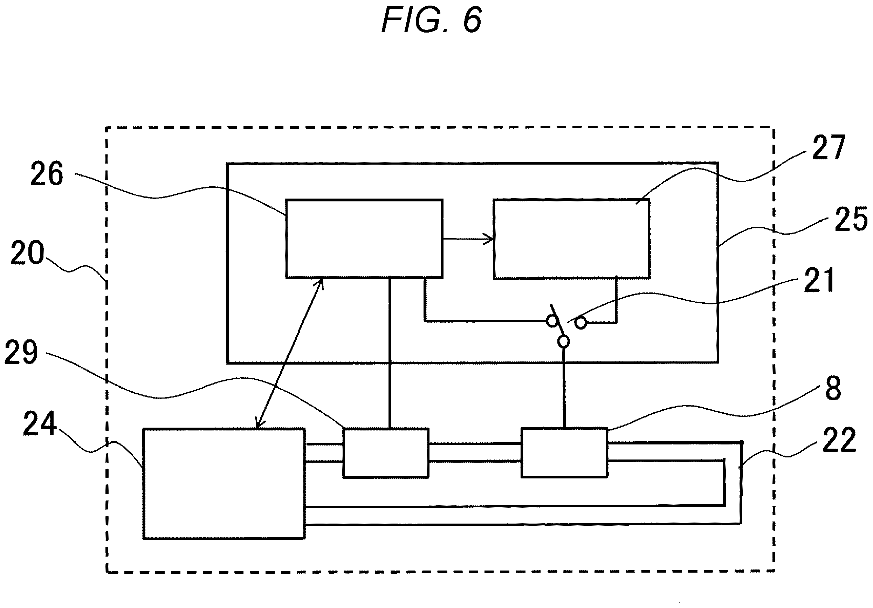

FIG. 6 illustrates calibration according to the present embodiment. A calibration device 20 has a configuration from which the current sensor 8 (product sensor) to be calibrated is at least eliminated. That is, the calibration device 20 includes a current sensor calibration unit 25, an alternating current generation unit 24, a bus bar 22, and a reference current sensor 29. The current sensor calibration unit 25 includes a current sensor output comparison unit 26, a current sensor communication unit 27, and a switch 21.

The reference current sensor 29 is a reference current sensor that can detect current flowing in the bus bar 22 with high accuracy.

The bus bar 22 is made of a conductor such as copper. The bus bar 22 is connected to the alternating current generation unit 24 at both ends thereof. The reference current sensor 29 and the current sensor 8 detect alternating current flowing in the bus bar 22 (below-mentioned calibration alternating current) and output detection signals to the current sensor output comparison unit 26.

The alternating current generation unit 24 is a single-phase alternating current generation source and mainly includes a not-illustrated voltage adjustment unit and a not-illustrated transformer. The alternating current generation unit 24 communicates with the current sensor output comparison unit 26 to receive an instruction from the current sensor output comparison unit 26 and output alternating current to the bus bar 22. This alternating current will be referred to as calibration alternating current.

The current sensor output comparison unit 26 instructs the alternating current generation unit 24 to output the calibration alternating current at the time of below-mentioned output gain adjustment. The current sensor output comparison unit 26 compares an output of the reference current sensor 29 with an output of the current sensor 8 and outputs the difference of the output voltage to the current sensor communication unit 27.

The current sensor communication unit 27 generates the correction data for correcting the setting data stored in the memory 15 of the current sensor 8 based on the aforementioned difference of the output voltage and outputs the correction data to the current sensor 8. The current sensor 8 corrects the setting data stored in the memory 15 with use of the correction data.

The switch 21 switches between the current sensor output comparison unit 26 and the current sensor communication unit 27 as a destination of the current sensor 8.

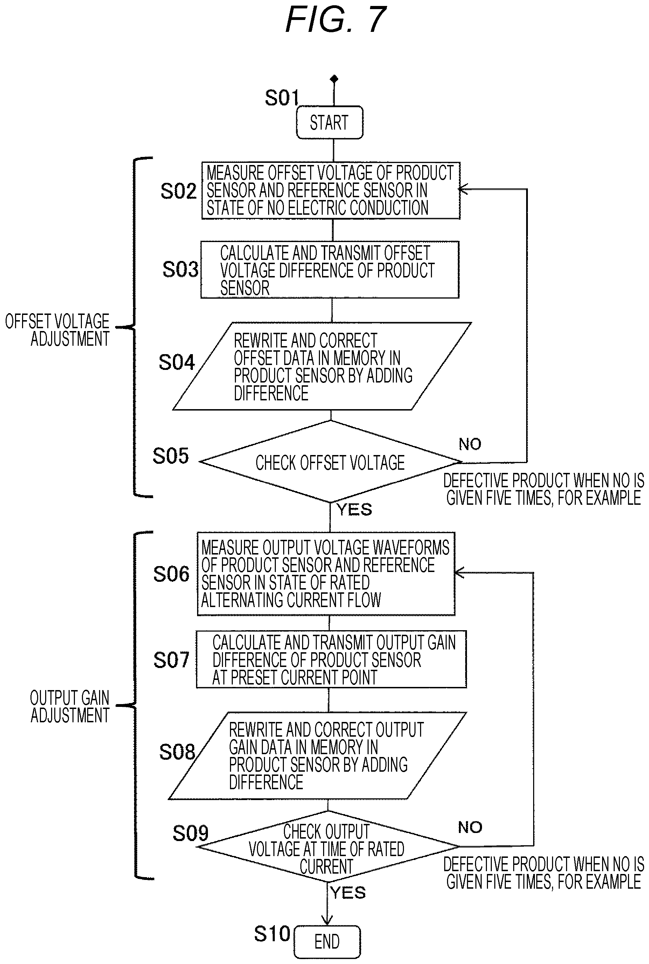

FIG. 7 is a flowchart of calibration according to the present embodiment. The flowchart includes an offset voltage adjustment process consisting of steps S02 to S05 and an output gain adjustment process consisting of steps S06 to S09. Note that "the product sensor" in FIG. 7 refers to the current sensor 8, and that "the reference sensor" refers to the reference current sensor 29. Hereinbelow, a procedure of the calibration according to the present embodiment will be described with reference to FIG. 7.

When the calibration flow is started (step S01), the procedure moves to step S02. In step S02, no current flows in the bus bar 22. In this state, the current sensor output comparison unit 26 measures respective offset voltage of the current sensor 8 and the reference current sensor 29. After step S02, the procedure moves to step S03.

In step S03, the current sensor output comparison unit 26 subtracts the offset voltage of the reference current sensor 29 from the offset voltage of the current sensor 8 to calculate an offset voltage error. The current sensor output comparison unit 26 transmits offset correction data including the offset voltage error to the current sensor communication unit 27. After step S03, the procedure moves to step S04.

In step S04, the current sensor communication unit 27 outputs the aforementioned offset correction data to the current sensor 8. In the current sensor 8, the control unit 13 corrects the offset data of the setting data stored in the memory 15 with use of the aforementioned offset correction data. Specifically, the control unit 13 adds the offset voltage error to the offset data of the setting data. After step S04, the procedure moves to step S05.

In step S05, the current sensor output comparison unit 26 measures respective offset voltage of the current sensor 8 and the reference current sensor 29 in a state of no electric conduction to the bus bar 22 in a similar manner to step S02. The current sensor output comparison unit 26 then checks if the voltage value of the offset voltage of the current sensor 8 falls within a targeted output range. That is, the current sensor output comparison unit 26 determines if the difference derived by subtracting the offset voltage of the reference current sensor 29 from the offset voltage of the current sensor 8 is equal to or less than a predetermined value. In a case of affirmative determination, the procedure moves to step S06. In a case of negative determination, the procedure moves to step S02, and the similar procedure follows. In a case in which the negative determination is given a predetermined number of times, such as five times, in step S05, the current sensor 8 is determined to be a defective product.

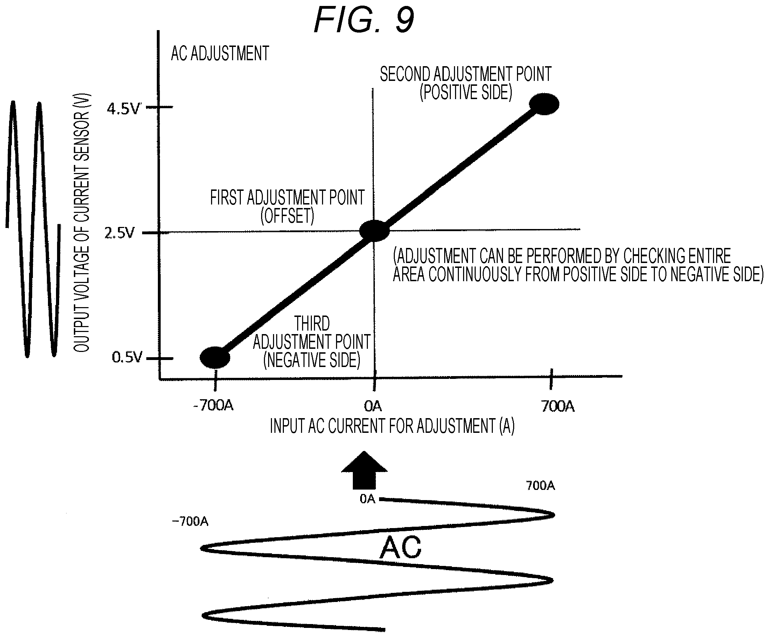

In step S06, the alternating current generation unit 24 provides the bus bar 22 with the calibration alternating current in response to an instruction of the current sensor output comparison unit 26. The frequency of the calibration alternating current is a frequency for the time when the current sensor 8 is actually used, that is, a frequency of alternating current to be measured. Also, due to a below-mentioned reason (refer to FIG. 9), the amplitude of the calibration alternating current is set to amplitude of the maximum current to be provided to the bus bar 22 when the current sensor 8 is actually used. The current sensor output comparison unit 26 measures respective output voltage waveforms output from the current sensor 8 and the reference current sensor 29. After step S06, the procedure moves to step S07.

In step S07, the current sensor output comparison unit 26 calculates an output gain error from the voltage waveforms of the current sensor 8 and the reference current sensor 29. The current sensor output comparison unit 26 transmits output gain correction data including the output gain error to the current sensor communication unit 27. After step S07, the procedure moves to step S08.

In step S08, the current sensor communication unit 27 outputs the aforementioned output gain correction data to the current sensor 8. In the current sensor 8, the control unit 13 corrects the output gain data of the setting data stored in the memory 15 with use of the aforementioned output gain correction data. Specifically, the control unit 13 adds the output gain error to the output gain data of the setting data. After step S08, the procedure moves to step S09.

In step S09, the current sensor output comparison unit 26 measures respective output voltage waveforms of the current sensor 8 and the reference current sensor 29 in a state in which the calibration alternating current flows in the bus bar 22 in a similar manner to step S06. The current sensor output comparison unit 26 then checks if the voltage amplified by the output gain of the current sensor 8 falls within a targeted output range. That is, the current sensor output comparison unit 26 determines if the difference between the amplitude of the output voltage waveform of the current sensor 8 and the amplitude of the output voltage waveform of the reference current sensor 29 is equal to or less than a predetermined value. In a case of affirmative determination, the procedure moves to step S10 to end the flow. In a case of negative determination, the procedure moves to step S06, and the similar procedure follows . In a case in which the negative determination is given a predetermined number of times, such as five times, in step S09, the current sensor 8 is determined to be a defective product.

By calibrating the current sensor 8 based on the flowchart illustrated in FIG. 7, the corrected setting data based on the detection value of the predetermined calibration alternating current detected by the magnetic flux detection unit 11 is stored in the memory 15. By adjusting the detection result of the alternating current detected by the magnetic flux detection unit 11 in the signal adjustment unit 12 with use of this corrected setting data, a detection error can be prevented from being generated when the current sensor 8 detects the alternating current.

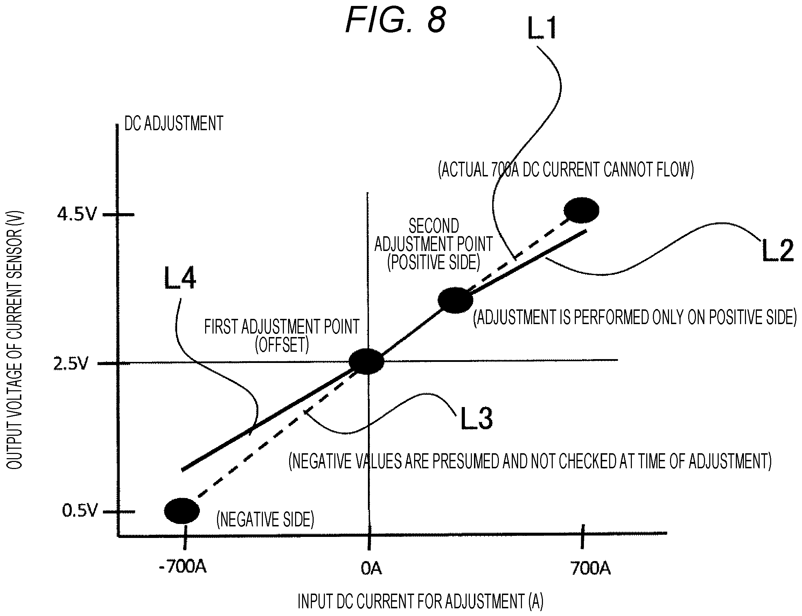

FIG. 8 illustrates an example of a relationship between input current and output voltage of the current sensor 8 at the time of calibration using direct current. In a case of calibration using direct current, the current needs to be provided until the measurement is completed in a state in which the current is stable. Thus, to prevent the product from being damaged by heat generation of the bus bar, calibration using a maximum current value (700 A in FIG. 8) cannot be performed in some cases. As a result, although calibration along a dashed line L1 is supposed to be performed, calibration along a solid line L2 may actually be performed.

Also, at the time of calibration using direct current, in many cases, calibration is performed at two points consisting of OA (first adjustment point) and the aforementioned positive-side current value at which calibration can be performed (second adjustment point) while calibration is not performed on the negative side. As a result, although calibration along a dashed line L3 is supposed to be performed, calibration along a solid line L4 may actually be performed.

As described above, in the case in which calibration is performed using direct current, there is a current area at which calibration is not performed, and an error may be generated in the output voltage due to a reason other than the aforementioned skin effect (refer to FIGS. 4(a), 4(b), and 5).

FIG. 9 illustrates an example of a relationship between input current and output voltage of the current sensor 8 at the time of calibration according to the present embodiment. In FIG. 9, calibration is performed using alternating current having the maximum amplitude of 700A, which may actually be used. As a matter of course, the frequency of the alternating current is set to a frequency that is to be used actually. As a result, calibration can be performed at a current area that is to be used actually, which is a range of from -700 A to +700 A. That is, at the entire current area to be used actually, voltage to be output from the current sensor 8 can have no error.

The current sensor according to the present embodiment is configured in the following manner and has the following effects.
(1) The current sensor 8 includes the magnetic flux detection unit 11 that detects magnetic flux generated by alternating current flowing in the bus bars 7 and 22 serving as conductors to detect the alternating current and the memory 15 that stores setting data based on a detection value of predetermined calibration alternating current flowing in the bus bar 22 detected by the magnetic flux detection unit 11.
   Accordingly, when the current sensor 8 detects alternating current, no detection error can be generated.
(2) The frequency of the calibration alternating current is determined based on a frequency of alternating current to be measured.
   Accordingly, when the current sensor 8 detects alternating current to be measured, no error can be generated.
(3) The current sensor 8 further includes the signal adjustment unit 12 and the communication unit 14 that output a detection signal based on the resultant alternating current detected by the magnetic flux detection unit 11 and the setting data stored in the memory 15.
   Accordingly, when the current sensor 8 detects alternating current and outputs a detection signal to an outside, a high-accuracy detection signal can be output.
(4) The current sensor 8 further includes the communication terminal 3 via which the detection signal is output and via which the correction data for the setting data is received.
   Accordingly, the number of communication terminals is not required to be increased unnecessarily, which can contribute to space saving.
(5) The current sensor 8 further includes the current sensor board 2 provided with the magnetic flux detection unit 11 and the memory 15, and the communication terminal 3 is provided on the current sensor board 2.
   Accordingly, the magnetic flux detection unit 11, the memory 15, and the communication terminal 3 can be provided together on the current sensor board 2.

### Second Embodiment

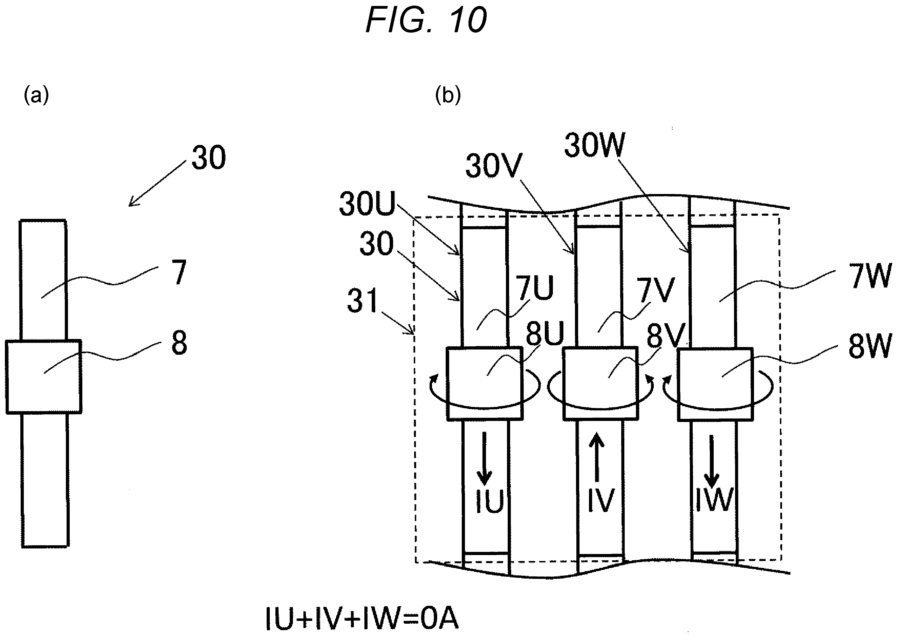

FIG. 10(a) illustrates a current detection unit 30. The current detection unit 30 is a unit in which the current sensor 8 is provided on the bus bar 7 and in which the current sensor 8 detects current flowing in the bus bar 7. The current detection unit 30 constitutes a current detection module 31 as illustrated in FIG. 10(b). The current detection module 31 includes as many current detection units 30 as the number of phases of alternating current to be used. FIG. 10(b) illustrates the current detection module 31 for three-phase alternating current. Since the current detection module 31 illustrated in FIG. 10(b) is configured to let three-phase alternating current flow, the current detection module 31 includes three current detection units 30. For the following description, reference signs of the three current detection units 30 illustrated in FIG. 10(b) will be 30U, 30V, and 30W, respectively. Also, reference signs of the bus bars included in the current detection units 30U, 30V, and 30W will be 7U, 7V, and 7W, respectively. Reference signs of the current sensors included in the current detection units 30U, 30V, and 30W will be 8U, 8V, and 8W, respectively.

FIG. 10(b) illustrates a state in which three-phase alternating current flows in the current detection module 31. U-phase, V-phase, and W-phase alternating current flows in the bus bars 7U, 7V, and 7W of the current detection units 30U, 30V, and 30W, respectively. That is, phases of alternating current flowing in the respective current detection units 30 differ from each other.

In such a current detection module 31, in which current of a plurality of phases flows, a problem occurs in which the current sensor of one current detection unit 30 detects magnetic flux generated by current flowing in another current detection unit 30. Details thereof will be described. In FIG. 10(b), directions of the U-phase and W-phase current are downward while a direction of the V-phase current is upward, and the directions of current flowing in the bus bars 7 of the adjacent current detection units 30 are opposite of each other. Consequently, the magnetic flux interferes with each other, and lower magnetic flux values than values that are supposed to be detected will be detected.

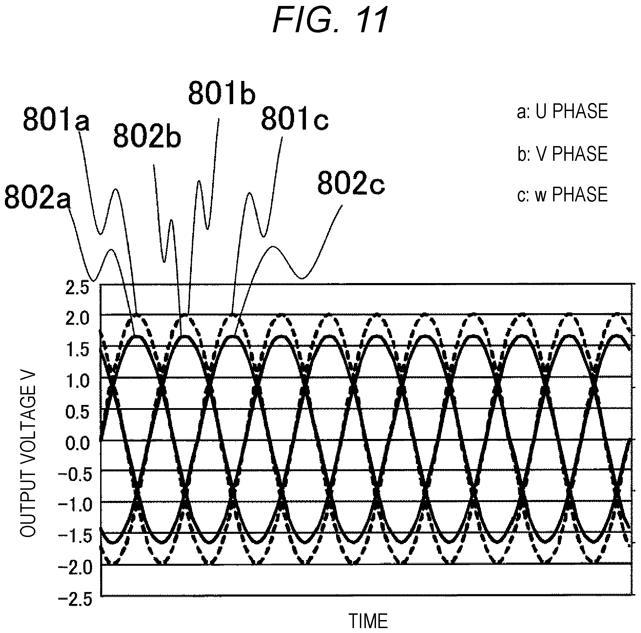

Solid lines 801a, 801b, and 801c illustrated in FIG. 11 represent voltage waveforms that the current detection module 31 illustrated in FIG. 10(b) outputs. The current detection units 30U, 30V, and 30W of the current detection module 31 are supposed to output voltage waveforms represented by dashed lines 802a, 802b, and 802c, respectively. However, due to the mutual interference, the current detection units 30U, 30V, and 30W output the solid lines 801a, 801b, and 801c. Thus, in a case in which the current detection module 31 is constituted by three current detection units 30 each of which is calibrated using single-phase alternating current and detects three-phase alternating current, an error as much as a difference between the solid line and the dashed line will be generated. Under such circumstances, in the present embodiment, calibration is performed using three-phase alternating current with use of three current sensors 8.

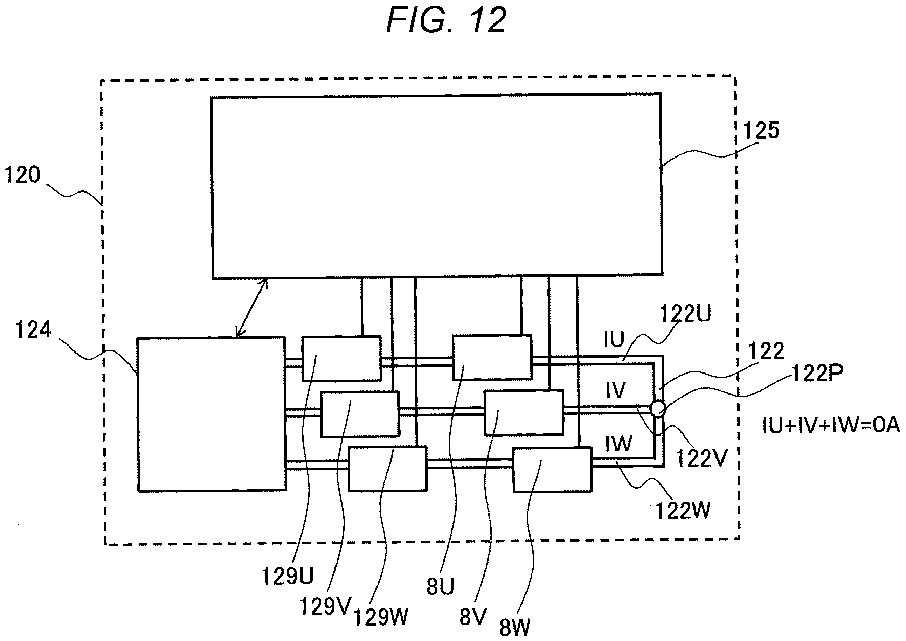

FIG. 12 illustrates calibration according to the present embodiment. Calibration according to the present embodiment will be described with reference to FIG. 12. Description of similar components to those in the first embodiment will be omitted.

In the present embodiment, calibration is performed using three-phase alternating current. This is a main difference from the calibration according to the first embodiment (FIG. 6) .

A calibration device 120 has a configuration from which the current sensors 8U, 8V, and 8W (product sensors) to be calibrated are at least eliminated. That is, the calibration device 120 includes a current sensor calibration unit 125, an alternating current generation unit 124, a bus bar 122, and reference current sensors 129U, 129V, and 129W. Meanwhile, the current sensor calibration unit 125 includes a current sensor output comparison unit, a current sensor communication unit, and a switch fitted to three-phase alternating current detection although these are not illustrated.

The bus bar 122 includes bus bars 122U, 122V, and 122W. Respective first ends of the bus bars 122U, 122V, and 122W are connected to each other at a point 122P while respective second ends thereof are connected to the alternating current generation unit 124. The bus bars 122U, 122V, and 122W are provided with the reference current sensors 129U, 129V, and 129W and the current sensors 8U, 8V, and 8W to be calibrated, respectively.

The alternating current generation unit 124 outputs three-phase alternating current in response to an instruction of the current sensor calibration unit 125. Thus, at the point 122P, the sum of current of the respective phases is zero. That is, IU + IV + IW = OA is established.

Description of a flowchart of the calibration according to the present embodiment will be omitted since the flowchart is similar to the calibration flowchart according to the first embodiment (FIG. 7) except the difference between the three phases and the single phase.

By performing calibration using the three-phase alternating current in this manner, an error caused by interference with alternating current of the other phases can be corrected, and no error will be included in an output of each of the current sensors 8. Also, in the present embodiment as well as in the first embodiment, no error (refer to FIG. 5) can be generated due to the skin effect. Further, calibration can be performed in the entire current range to be used (refer to FIG. 9) .

The current sensor according to the present embodiment is configured in the following manner and has the following effects in addition to the effects according to the first embodiment.

The magnetic flux detection unit 11 detects magnetic flux generated by three-phase alternating current flowing in the three bus bars to respectively detect the three-phase alternating current flowing in the three bus bars. Calibration alternating current is also three-phase alternating current corresponding to the targets to be measured, and current of the respective phases flows in the three respective bus bars.

Accordingly, an error caused by interference with alternating current of the other phases can be corrected, and no error will be included in an output of each of the current sensors 8.

### Third Embodiment

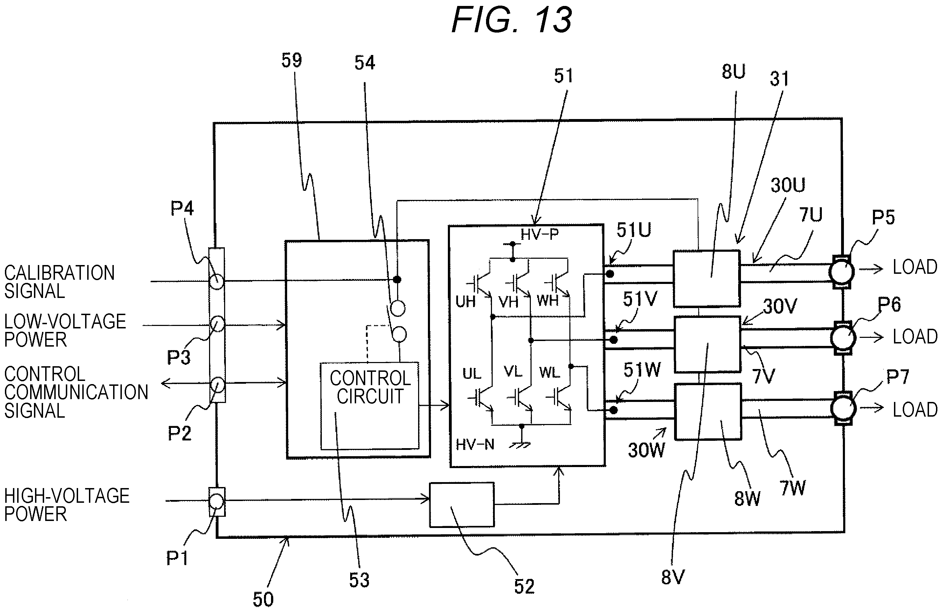

FIG. 13 illustrates a power inversion device 50 (inverter device 50) including the current sensor 8. The current sensor 8 is provided in the current detection module 31 for detection of three-phase alternating current as illustrated in FIG. 10 (b) . The current detection module 31 is provided in the power inversion device 50 to cause the current sensor 8 to be provided in the power inversion device 50.

The power inversion device 50 includes the current detection module 31, an inverter circuit 51, a smoothing capacitor 52, an inverter circuit board 59, and terminals P1, P2, P3, P4, P5, P6, and P7.

Respective first ends of the bus bars 7U, 7V, and 7W of the current detection module 31 on the right side of the figure are connected to the terminals P5, P6, and P7, respectively. To the terminals P5, P6, and P7, loads such as three-phase motors are normally connected. Also, respective second ends of the bus bars 7U, 7V, and 7W of the current detection module 31 on the left side of the figure are connected to output terminals 51U, 51V, and 51W of the inverter circuit 51, respectively.

The inverter circuit 51 is connected via the smoothing capacitor 52 and the terminal P1 to a not-illustrated high-voltage power source and is supplied from the high-voltage power source with power to be output to an outside via the terminals P5, P6, and P7. The inverter circuit 51 includes high-side U-phase switch UH, V-phase switch VH, and W-phase switch WH and low-side U-phase switch UL, V-phase switch VL, and W-phase switch WL. These switches are controlled by a control circuit 53.

The inverter circuit board 59 includes the control circuit 53 and a switch 54. The control circuit 53 is supplied from a not-illustrated low-voltage power source with low-voltage power via the terminal P3. The control circuit 53 receives a control communication signal from a not-illustrated control device via the terminal P2 and is operated. The control circuit 53 controls the switch 54 as well as the switches UH, VH, WH, UL, VL, and WL included in the inverter circuit 51. The switch 54 is controlled so that the switch 54 may be turned off in a case of below-mentioned calibration and may be turned on in the other cases (normal cases). The control circuit 53 receives detection signals from the current sensors 8U, 8V, and 8W in normal cases. The reason for turning off the switch 54 in the case of calibration is to prevent a signal of the communication terminal 3 from being input in the control circuit 53 to enable the setting data of the current sensor 8 to be corrected (rewritten) normally by a calibration device.

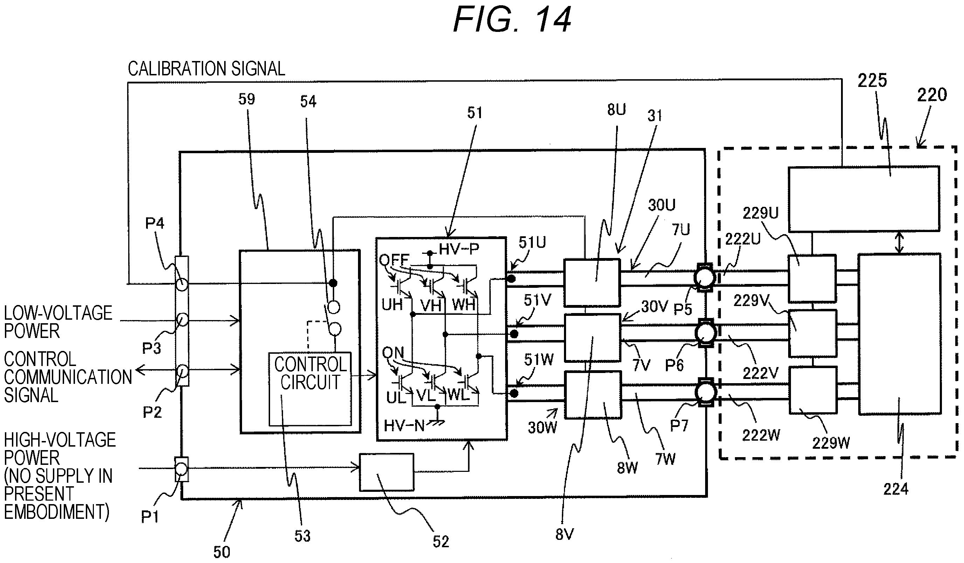

FIG. 14 illustrates calibration according to the present embodiment. In the present embodiment, the current sensors 8U, 8V, and 8W are calibrated by attaching a calibration device 220 to the power inversion device 50. The calibration device 220 includes a current sensor calibration unit 225, an alternating current generation unit 224, bus bars 222U, 222V, and 222W, and reference current sensors 229U, 229V, and 229W. Meanwhile, the current sensor calibration unit 225 includes a current sensor output comparison unit, a current sensor communication unit, and a switch fitted to three-phase alternating current detection although these are not illustrated.

The bus bars 222U, 222V, and 222W of the calibration device 220 are connected to the terminals P5, P6, and P7 of the power inversion device 50, respectively. Three-phase calibration alternating current generated from the alternating current generation unit 224 is input via the bus bars 222U, 222V, and 222W and the terminals P5, P6, and P7 to the power inversion device 50, respectively. Thus, the three-phase calibration alternating current flows in the bus bars 7U, 7V, and 7W. At this time, detection signals output from the current sensors 8U, 8V, and 8W of the power inversion device 50 are input in the current sensor calibration unit 225. Output signals of the reference current sensors 229U, 229V, and 229W are also input in the current sensor calibration unit 225. The current sensor calibration unit 225 calculates differences between the detection signals of the current sensors 8U, 8V, and 8W and the output signals of the reference current sensors 229U, 229V, and 229W in terms of the U phase, V phase, and W phase, respectively. Based on the differences, the current sensor calibration unit 225 generates correction data for correcting the setting data of the respective phases and outputs the correction data to the current sensors 8U, 8V, and 8W, respectively. The switch 54 is controlled so that the switch 54 may be turned off at the time of correcting the setting data stored in the memory 15 of the current sensor circuit 1 of the current sensor 8, that is, at the time of calibration. After the switch 54 is turned off to disconnect the calibration device 220 from the control circuit 53, the calibration device 220 corrects the aforementioned setting data.

Meanwhile, at the time of the calibration according to the present embodiment, power supply from the high-voltage power source is stopped. Also, in the inverter circuit 51, the high-side U-phase switch UH, V-phase switch VH, and W-phase switch WH are turned off. Conversely, the low-side U-phase switch UL, V-phase switch VL, and W-phase switch WL are turned on. In such switch states, a point corresponding to the point 122P illustrated in FIG. 12 is formed in the inverter circuit 51, and current flowing in the three-phase bus bars 7U, 7V, and 7W gets together at one point. Connection in the calibration according to the present embodiment is in the above manner. Description of a flowchart of the calibration according to the present embodiment will be omitted since the flowchart is similar to that according to the second embodiment.

The current sensor according to the present embodiment is configured in the following manner and has the following effects.

The current sensor 8 is mounted on the power inversion device 50 including the inverter circuit 51 including the plurality of switching elements UH, UL, VH, VL, WH, and WL, the inverter direct-current terminal P1 electrically connected to the inverter circuit 51, and the inverter alternating-current terminals P5, P6, and P7 electrically connected to the inverter circuit 51.

The plurality of bus bars 7U, 7V, and 7W are connected to the inverter circuit 51 and the inverter alternating-current terminals P5, P6, and P7.

The respective switching elements UH, UL, VH, VL, WH, and WL of the inverter circuit 51 are in predetermined switch states . That is, the high-side U-phase switch UH, V-phase switch VH, and W-phase switch WH are turned off. Conversely, the low-side U-phase switch UL, V-phase switch VL, and W-phase switch WL are turned on.

By connecting the inverter alternating-current terminals P5, P6, and P7 to the alternating current generation unit 224 serving as a calibration current source provided outside the power inversion device 50, calibration alternating current flows in the plurality of bus bars 7U, 7V, and 7W.

Accordingly, the current sensor 8 can be calibrated without disconnecting the current sensor 8 from the power inversion device 50. Also, unlike the second embodiment, since the current sensor 8 is calibrated in the power inversion device 50, on which the current sensor 8 is actually mounted, calibration can be performed under conditions more similar to actual use environment conditions (for example, conditions such as a magnetic flux density distribution).

### Fourth Embodiment

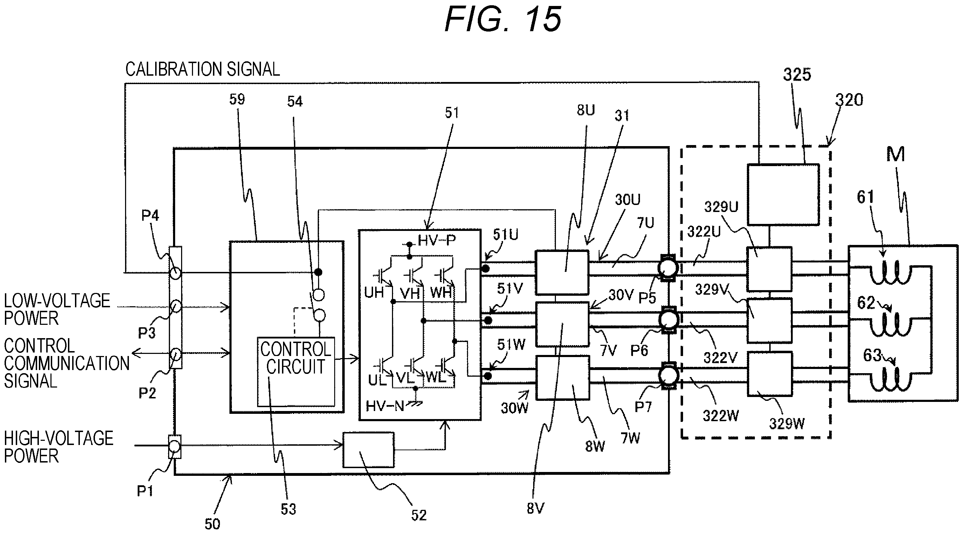

FIG. 15 illustrates calibration according to the present embodiment. In the present embodiment as well, the current sensor 8 is mounted on the power inversion device 50 illustrated in FIG. 13 and is calibrated in this state. As main differences from the third embodiment, a calibration device 320 includes no alternating current generation unit, the calibration device 320 is connected to a motor M as well, and calibration is performed using alternating current output from the power inversion device 50. Description of similar components to those in the third embodiment will be omitted.

In the present embodiment, the current sensor 8 is calibrated when the power inversion device 50 outputs alternating current to the motor M serving as a load. The calibration device 320 according to the present embodiment is provided between the power inversion device 50 and the motor M. First ends of winding wires 61, 62, and 63 of the motor M are connected to the calibration device 320 while second ends of the winding wires 61, 62, and 63 are connected to each other. The calibration device 320 includes a current sensor calibration unit 325, bus bars 322U, 322V, and 322W, and reference current sensors 329U, 329V, and 329W. That is, the calibration device 320 includes no alternating current generation unit. In the present embodiment, high-voltage power of the power inversion device 50 from the high-voltage power source is used. The control circuit 53 controls the switches UH, UL, VH, VL, WH, and WL so that the inverter circuit 51 may output three-phase alternating current. The alternating current output from the inverter circuit 51 flows in the bus bars 7U, 7V, and 7W, passes through the terminals P5, P6, and P7, flows in the bus bars 322U, 322V, and 322W of the calibration device 320, and reaches the U-phase winding wire 61, V-phase winding wire 62, and W-phase winding wire 63 of the motor M. At this time, detection signals output from the current sensors 8U, 8V, and 8W of the power inversion device 50 are input in the current sensor calibration unit 325. Output signals of the reference current sensors 329U, 329V, and 329W are also input in the current sensor calibration unit 325. The current sensor calibration unit 325 calculates differences between the detection signals of the current sensors 8U, 8V, and 8W and the output signals of the reference current sensors 329U, 329V, and 329W in terms of the U phase, V phase, and W phase, respectively. Based on the differences, the current sensor calibration unit 325 generates correction data for correcting the setting data of the respective phases and outputs the correction data to the current sensors 8U, 8V, and 8W, respectively. The switch 54 is controlled so that the switch 54 may be turned off at the time of correcting the setting data stored in the memory 15 of the current sensor circuit 1 of the current sensor 8, that is, at the time of calibration. After the switch 54 is turned off to disconnect the calibration device 320 from the control circuit 53, the calibration device 220 corrects the aforementioned setting data.

Description of a flowchart of the calibration according to the present embodiment will be omitted since the flowchart is similar to that according to the second or third embodiment.

The current sensor according to the present embodiment is configured in the following manner and has the following effects.

The current sensor 8 is mounted on the power inversion device 50 including the inverter circuit 51 including the plurality of switching elements UH, UL, VH, VL, WH, and WL for inverting direct current into alternating current and the inverter output terminals P5, P6, and P7 for outputting alternating current.

The plurality of bus bars 7U, 7V, and 7W are connected to the inverter circuit 51 and the inverter output terminals P5, P6, and P7.

By outputting alternating current from the inverter circuit 51 to the motor M connected to the inverter output terminals P5, P6, and P7, calibration alternating current flows in the plurality of bus bars 7U, 7V, and 7W.

In this manner, in the present embodiment, calibration is performed using alternating current that the power inversion device 50 actually outputs. Since a target to be measured by the current sensor 8 is this alternating current, an error can be prevented from being included in a detection signal that the current sensor 8 outputs further than in the third embodiment.

The following modifications are within the scope of the present invention.

Although the structure mold 6 illustrated in FIGS. 1 and 2 is fixed to the bus bar 7, the present invention is not limited to this. For example, the structure mold 6 may be fixed to the inverter circuit board 9 or may be provided integrally with a mold member included in the inverter circuit board 9.

Although the current sensor board illustrated in FIGS. 1 and 2 is separated from the inverter circuit board, the current sensor board may be provided integrally with the inverter circuit board.

Although the magnetic shield 5 illustrated in FIG. 2 is formed in the rectangular U shape, the present invention is not limited to this. For example, the magnetic shield 5 may be in a round U shape or in a shield shape divided into plural pieces.

The memory 15 of the current sensor 8 may be able to store setting data for a plurality of frequencies. In this case, one or a plurality of frequencies can be used for alternating current for use in calibration. Also, one of the frequencies may be zero, that is, may be applied to direct current.

The magnetic flux detection unit 11 in FIG. 3 may include a magnetic flux detection element other than the hall element. For example, the magnetic flux detection unit 11 may include a giant magnetoresistance element (GMR element).

Although the configuration in which the three-phase alternating current is targeted for measurement has been described in each of the second to fourth embodiments, the present invention is not limited to this. The present invention can be applied when multiphase alternating current of N (N is an integer of at least two) phases is targeted for measurement. Also, as described in the first embodiment, the present invention can be applied when single-phase alternating current is targeted for measurement.

In the flowchart in FIG. 7, the setting data (offset data and output gain data) stored in the memory 15 is corrected based on the correction data received from the current sensor communication unit 27 of the calibration device 20 to calibrate the current sensor 8. However, the setting data and the correction data may be stored in the memory 15, and based on the data, the calibrated setting data may be output from the control unit 13 to the signal adjustment unit 12.

The present invention is not limited to the contents described above. Other aspects conceivable within the scope of the technical idea of the present invention are included in the scope of the present invention.

### Reference Signs List

- 1: current sensor circuit
- 2: current sensor board
- 3: communication terminal
- 4: peripheral electronic component
- 5: magnetic shield
- 6: structure mold
- 7: bus bar
- 8: current sensor
- 9: inverter circuit board
- 11: magnetic flux detection unit
- 12: signal adjustment unit
- 13: control unit
- 14: communication unit
- 15: memory
- 20, 120, 220, 320: calibration device
- 21: switch
- 22: bus bar
- 24: alternating current generation unit
- 25: current sensor calibration unit
- 26: current sensor output comparison unit
- 27: current sensor communication unit
- 29: reference current sensor
- 30: current detection unit
- 31: current detection module
- 50: power inversion device (inverter device)
- 51: inverter circuit
- 51U, 51V, 51W: output terminal
- 52: smoothing capacitor
- 53: control circuit
- 54: switch
- 59: inverter circuit board
- 61: U-phase winding wire
- 62: V-phase winding wire
- 63: W-phase winding wire
- M: motor
- P1, P2, P3, P4, P5, P6, P7: terminal

## Claims

1. A current sensor comprising:
a current detection unit that detects alternating current flowing in a conductor; and
a storage unit that stores setting data based on a detection value of predetermined calibration alternating current flowing in the conductor, the detection value being detected by the current detection unit.

2. The current sensor according to claim 1, further comprising:
a signal output unit that outputs a detection signal based on the resultant alternating current detected by the current detection unit and the setting data stored in the storage unit.

3. The current sensor according to claim 1 or 2, wherein a frequency of the calibration alternating current is determined based on a frequency of the alternating current to be measured.

4. The current sensor according to claim 1 or 2, wherein the current detection unit respectively detects the alternating current flowing in a plurality of conductors, and
wherein the calibration alternating current is multiphase alternating current, and current of respective phases flows in the plurality of conductors.

5. The current sensor according to claim 4, wherein the current sensor is mounted on a power inversion device that includes an inverter circuit including a plurality of switching elements, an inverter direct-current terminal electrically connected to the inverter circuit, and an inverter alternating-current terminal electrically connected to the inverter circuit,
wherein the plurality of conductors are connected to the inverter circuit and the inverter alternating-current terminal,
wherein the respective switching elements of the inverter circuit are in predetermined switch states, and
wherein, by connecting the inverter alternating-current terminal to a calibration current source provided outside the power inversion device, the calibration alternating current flows in the plurality of conductors.

6. The current sensor according to claim 4, wherein the current sensor is mounted on a power inversion device that includes an inverter circuit including a plurality of switching elements for inverting direct current into alternating current and an inverter output terminal for outputting the alternating current,
wherein the plurality of conductors are connected to the inverter circuit and the inverter output terminal, and
wherein, by outputting the alternating current from the inverter circuit to a load connected to the inverter output terminal, the calibration alternating current flows in the plurality of conductors.

7. The current sensor according to claim 1 or 2, further comprising:
a communication terminal that outputs the detection signal and receives correction data for the setting data.

8. The current sensor according to claim 7, further comprising:
a board that is provided with at least the current detection unit and the storage unit,
wherein the communication terminal is provided in the board.
